Europäisches Patentamt

European Patent Office

Office européen des brevets

(19)

(11) **EP 0 811 181 B1**

(12) **EUROPÄISCHE PATENTSCHRIFT**

(45) Veröffentlichungstag und Bekanntmachung des Hinweises auf die Patenterteilung:
**09.09.1998   Patentblatt 1998/37**

(51) Int Cl.⁶: **G03F 7/20**

(86) Internationale Anmeldenummer:
**PCT/EP96/01737**

(21) Anmeldenummer: **96914126.6**

(22) Anmeldetag: **25.04.1996**

(87) Internationale Veröffentlichungsnummer:
**WO 97/01130 (09.01.1997 Gazette 1997/03)**

(54) **VERFAHREN UND VORRICHTUNG ZUM STRUKTURIEREN EINER PHOTOLITHOGRAPHISCHEN SCHICHT**

METHOD AND DEVICE FOR PRODUCING FEATURES ON A PHOTOLITHOGRAPHIC LAYER

PROCEDE ET DISPOSITIF DE STRUCTURATION D'UNE COUCHE PHOTOLITOGRAPHIQUE

(84) Benannte Vertragsstaaten:
**CH DE FR GB LI NL SE**

(30) Priorität: **23.06.1995  DE 19522936**

(43) Veröffentlichungstag der Anmeldung:
**10.12.1997   Patentblatt 1997/50**

(73) Patentinhaber: **FRAUNHOFER-GESELLSCHAFT ZUR FÖRDERUNG DER ANGEWANDTEN FORSCHUNG E.V. 80636 München (DE)**

(72) Erfinder:
• **PAUFLER, Jörg D-01877 Bischofswerda (DE)**
• **SELTMANN, Rolf D-01477 Arnsdorf (DE)**
• **KÜCK, Heinz D-01465 Langebrück (DE)**

(74) Vertreter: **Schoppe, Fritz, Dipl.-Ing. et al Schoppe & Zimmermann Patentanwälte Postfach 71 08 67 81458 München (DE)**

(56) Entgegenhaltungen:
EP-A- 0 632 330          WO-A-94/24610
US-A- 5 132 723          US-A- 5 369 464

## Beschreibung

Die vorliegende Erfindung betrifft ein Verfahren und eine Vorrichtung zur Strukturierung photolithographischer Schichten, insbesondere für die Mikroelektronik, die Mikrosystemtechnik, die Dünnfilmtechnik, die Fertigung von flachen Bildschirmen, die Direktbelichtung von Halbleiterwafern in der Halbleiterfertigung und die Strukturierung von Masken und Retikeln für mikrolithographische Anwendungen.

Im Stand der Technik sind bereits Belichtungsvorrichtungen für die Direktbelichtung von lichtempfindlichen Schichten bekannt.

Die WO 93/09472 beschreibt eine Belichtungsvorrichtung, die eine Lichtquelle und einen Mustergenerator umfaßt. Der Mustergenerator weist ein optisches Schlierensystem und einen aktiven, Matrix-adressierbaren Flächenlichtmodulator auf. Ferner umfaßt diese bekannte Belichtungsvorrichtung einen verfahrbaren Positioniertisch, auf dem ein zu belichtendes Substrat festlegbar ist. Als Lichtquelle wird dort ein gepulster Laser eingesetzt, dessen Pulsdauer so kurz ist, daß bei einer kontinuierlichen Bewegung des das Substrat tragenden Positioniertisches während der Belichtung eines Einzelbildes keine die Abbildungsqualität beeinträchtigenden Bildverwaschungen auftreten. Auf diese Art und Weise sind relativ hohe Schreibgeschwindigkeiten erreichbar.

Die WO 91/17483 und die WO 93/09469 beschreiben ähnliche Belichtungsvorrichtungen zur Direktbelichtung von lichtempfindlichen Schichten, bei denen diese Belichtung ebenfalls durch einen Flächenlichtmodulator erfolgt.

Der Nachteil der oben beschriebenen Belichtungseinrichtungen besteht darin, daß durch die Größe der Bildelemente (Pixel), insbesondere durch die Breite der Bildelemente auf dem Flächenlichtmodulator und aufgrund des Abbildungsmaßstabes einer Projektionsoptik ein Strukturinkrement fest vorgegeben ist und nicht beliebig verkleinert werden kann. Ein Strukturinkrement ist die kleinste Einheit, um die eine Struktur auf dem zu belichtenden Substrat vergrößert oder verkleinert werden kann.

Insbesondere tritt ein Widerspruch zwischen der theoretischen Strukturauflösung eines Matrix-adressierten Flächenlichtmodulators von einem oder zwei Pixeln und dem Strukturinkrement von einem Pixel auf, da nahezu alle Technologien in einem Halbleiterprozeß auf einem Verhältnis des Strukturinkrements zu minimaler Strukturgröße von kleiner als 1:10 basieren.

Mit dem im Stand der Technik bekannten und oben beschriebenen Belichtungseinrichtungen kann das Strukturinkrement nur in einem technologisch bzw. technisch beschränkten Rahmen durch Vergrößerung des Abbildungsmaßstabes der Projektionsoptik oder durch die Verringerung der Breite der Bildelemente auf dem Flächenlichtmodulator reduziert werden.

Dies führt in beiden Fällen zu einer erheblichen Verringerung der Schreibgeschwindigkeit des Systems, die zu dem Quadrat des Produktes aus der Breite des Bildelements auf dem Flächenlichtmodulator und dem Abbildungsmaßstab proportional ist.

Einen weiteren Nachteil dieser bekannten Vorrichtungen stellt die Defektempfindlichkeit dieser Vorrichtungen dar. Aufgrund der Größe der eingesetzten Flächenlichtmodulatoren sind auf dem Flächenlichtmodulator in der Regel Defekte nicht ausschließbar, d.h., daß eine Anzahl von Bildelementen nicht oder nicht vollständig adressiert werden kann.

Die WO 93/09472 löst dieses Problem dadurch, daß alle defekten Bildelemente ermittelt und derart bearbeitet werden, daß diese nicht länger Licht reflektieren. Bei dieser bekannten Vorrichtung wird eine Struktur durch einander überlappende Teilbilder erzeugt, so daß sichergestellt ist, daß jeder Teil der zu belichtenden Struktur wenigstens einmal durch ein funktionsfähiges Bildelement belichtet ist. Diese Überlappung von zwei nebeneinanderliegenden Einzelbildern auf dem Substrat führt zu einer Reduzierung der Schreibgeschwindigkeit dieser bekannten Vorrichtung um einen weiteren Faktor von zwei.

Ausgehend von dem oben beschriebenen Stand der Technik liegt der vorliegenden Erfindung die Aufgabe zugrunde, ein Verfahren und eine Vorrichtung zum Strukturieren einer photolithographischen Schicht zu schaffen, bei dem eine Beschränkung der Größe eines Strukturinkrements aufgrund der Bildelementbreite des Flächenlichtmodulators und aufgrund des Abbildungsmaßstabes des Projektionsobjektivs ohne Beeinträchtigung der Schreibgeschwindigkeit aufgehoben wird.

Diese Aufgabe wird durch ein Verfahren nach Anspruch 1 und durch eine Vorrichtung nach Anspruch 7 gelöst.

Der vorliegenden Erfindung liegt die Erkenntnis zugrunde, daß es durch die endliche Apertur der optischen Abbildungseinrichtung an den Rändern der Strukturen zu einer Abnahme der Lichtintensität kommt, so daß eine abzubildende Kante "verwaschen" erscheint. Im Zusammenhang mit dem Kontrast des verwendeten Resists, der ein Maß für den Resistabtrag bei einer Veränderung der Lichtintensität ist, und der auf dem Resist auftreffenden Lichtintensität kann durch eine Variation der Steilheit des Intensitätsverlaufs an der abzubildenden Strukturkante die Breite der erzeugten Resiststruktur beeinflußt werden. Im idealen Grenzfall eines Resists mit unendlich hohen Kontrast existiert eine sogenannte Ansprechintensität des Resists. Eine Strukturkante wird in diesem Fall durch den Schnittpunkt des Intensitätsverlaufs mit der Ansprechintensität des Resists festgelegt.

Durch das Abbilden eines ersten Musters und eines zweiten Musters, das mit dem ersten Muster übereinstimmt und unmittelbar benachbart zu diesem einen zweiten Bereich von adressierten Bildelementen aufweist, ist es möglich, einen Verlauf der Lichtintensität über den Randbereich der Strukturen festzulegen. Dadurch ist es möglich, die Kante der Struktur, die durch den Kontrast des verwendeten Resists und den Absolutwert und die Kantensteilheit der auftreffenden Lichtintensität festgelegt ist, gezielt zu verschieben. Hierdurch wird eine Verkleinerung des erreichbaren Strukturinkrements auf der zu belichtenden Schicht ohne Änderung der Breite der Bildelemente auf dem Flächenlichtmodulator und ohne Änderung des Abbildungsmaßstabs der optischen Abbildungseinrichtung erreicht.

Gemäß weiterer Vorteil der vorliegenden Erfindung werden ferner auch defekte Bildelemente auf dem Flächenlichtmodulator toleriert, so daß die volle Leistungsfähigkeit der erfindungsgemäßen Vorrichtung ohne Verringerung der Schreibgeschwindigkeit gewährleistet ist.

Bevorzugte Weiterbildungen der vorliegenden Erfindung sind in den Unteransprüchen definiert.

Anhand der beiliegenden Zeichnungen werden nachfolgend bevorzugte Ausführungsbeispiele der vorliegenden Erfindung näher beschrieben. Es zeigen:

Fig. 1 eine Darstellung, anhand der das erfindungsgemäße Verfahren beschrieben wird;

Fig. 2 eine weitere Darstellung, anhand der das erfindungsgemäße Verfahren beschrieben wird;

Fig. 3 ein erstes Ausführungsbeispiel der erfindungsgemäßen Vorrichtung; und

Fig. 4 ein zweites Ausführungsbeispiel der erfindungsgemäßen Vorrichtung.

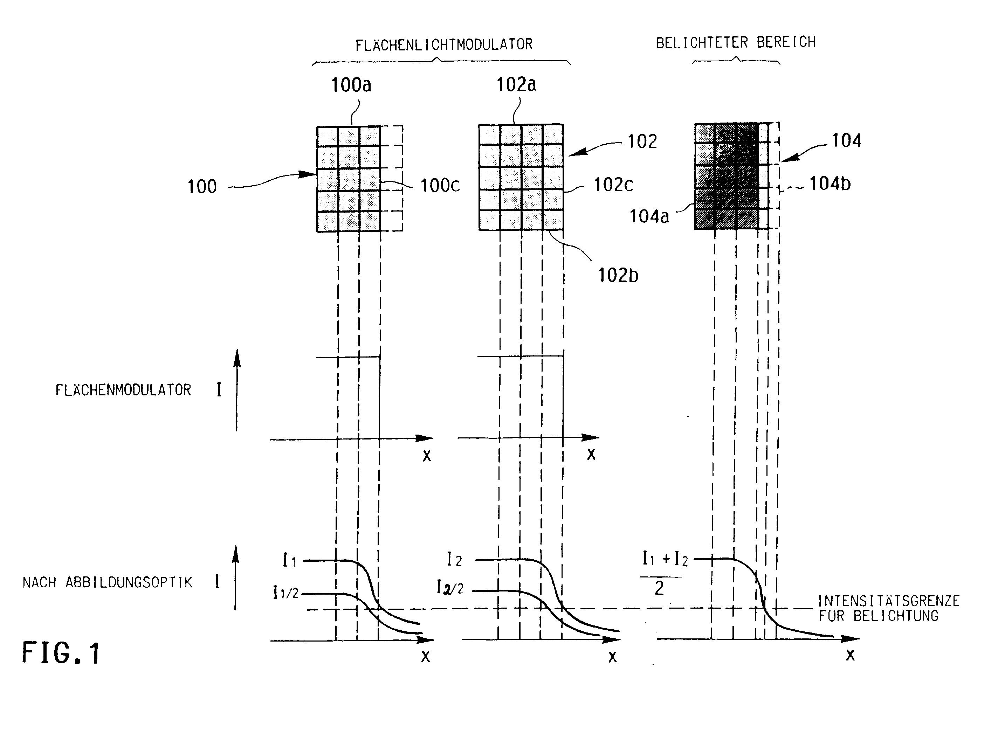

In Fig. 1 ist ein erstes Muster 100 und ein zweites Muster 102 dargestellt. Das erste Muster 100 ist auf einem Flächenlichtmodulator erzeugt und besteht bei diesem Ausführungsbeispiel aus 3 x 5 adressierten Bildelementen. Das zweite Muster 102 ist ebenfalls auf einem Flächenlichtmodulator erzeugt und besteht aus 4 x 5 adressierten Bildelementen. Das zweite Muster 102 weist einen ersten Bereich 102a von 3 x 5 adressierten Bildelementen auf, der einem Bereich 100a entspricht. Benachbart zu dem ersten Bereich 102a des zweiten Musters ist ein zweiter Bereich 102b mit 1 x 5 adressierten Bildelementen des zweiten Musters angeordnet.

In Fig. 1 ist mit 104 der sich ergebende belichtete Bereich auf der zu strukturierenden Schicht dargestellt. Wie deutlich zu erkennen ist, ergibt sich aus einer Überlagerung des ersten Musters 100 und des zweiten Musters 102 ein belichteter Bereich 104, der einen ersten Abschnitt 104a aufweist, der dem ersten Muster 100 entspricht. Ferner ergibt sich ein zweiter Abschnitt 104b, der eine Breite hat, die der halben Breite eines Bildelements des Flächenlichtmodulators entspricht.

Das Zustandekommen dieses zweiten Abschnitts wird nachfolgend anhand der Intensitätsverläufe im unteren Teil der Fig. 1 näher erläutert.

Der erste Intensitätsverlauf stellt die Intensität des Lichtes dar, das aufgrund des ersten bzw. zweiten Musters 100, 102 vom Flächenlichtmodulator reflektiert wird. Es ist deutlich ein scharfer Übergang zwischen Bildelementen des Flächenlichtmodulators, die das erste bzw. zweite Muster definieren, und zwischen Bildelementen des Flächenlichtmodulators, die keinen Teil der Muster definieren, zu erkennen.

Wie es bereits oben beschrieben wurde, weist die Abbildungsoptik eine endliche Apertur auf. Dies führt dazu, daß der ursprünglich scharfe Übergang der Lichtintensität nach dem Flächenlichtmodulator "verwäscht".

In Fig. 1 wird zur Erläuterung der Auswirkung der Intensitätsverläufe auf die Strukturkanten ein ideales Resist mit unendlich hohen Kontrast angenommen. Dies hat zur Folge, daß eine Strukturkante durch den Schnittpunkt des Intensitätsverlaufs mit der Ansprechintensität festgelegt ist.

Im unteren Teil der Fig. 1 ist der Intensitätsverlauf des Lichtes nach dem Durchlaufen der Abbildungsoptik dargestellt. Mit $I_1$ ist die Lichtintensität bezeichnet, die erforderlich ist, um den zu belichtenden Bereich mit allen 3 x 5 adressierten Bildelementen des ersten Musters 100 zu belichten. Mit $I_2$ ist die Lichtintensität bezeichnet, die erforderlich ist, um den zu belichtenden Bereich mit allen 4 x 5 adressierten Bildelementen des zweiten Musters 102 zu belichten.

Um die Kante 100c des ersten Musters 100 gezielt zu verschieben, werden die Muster 100, 102 jedoch nicht mit der Intensität, $I_1$ bzw. $I_2$, belichtet, die erforderlich ist, um das vollständige Muster abzubilden, sondern es werden geringere Intensitäten verwendet, die unterhalb der obengenannten Intensitäten liegen. Die entsprechenden Intensitäten hängen von dem verwendeten Resist ab.

Bei dem in Fig. 1 dargestellten Beispiel seien diese geringeren Intensitäten $I_1/2$ bzw. $I_2/2$.

Betrachtet man nun jedes Muster 100, 102 bei Verwendung der geringeren Intensität für sich allein, so fallen die Intensitäten bereits frühzeitig unter die Ansprechintensität des Resists ab, d.h. es wird nur ein schmaler Teil des Musters (3 x 5 bzw. 4 x 5) abgebildet.

Bei einer Überlagerung der beiden Muster, genauer gesagt bei einer Überlagerung der entsprechenden Intensitätsverläufe für $I_1/2$ bzw. $I_2/2$, ergibt sich ein Intensitätsverlauf in dem belichteten Bereich von $(I_1 + I_2)/2$, wie er in Fig. 1 unten rechts dargestellt ist.

Es ergibt sich eine Verschiebung des Schnittpunkts des Intensitätsverlaufs mit der Intensitätsgrenze.

Hieraus ergibt sich der belichtete Bereich 104 mit seinem ersten und seinem zweiten Abschnitt 104a, 104b, wobei der zweite Abschnitt 104b eine Breite aufweist, die der halben Breite eines Bildelements eines Flächenlichtmodulators entspricht.

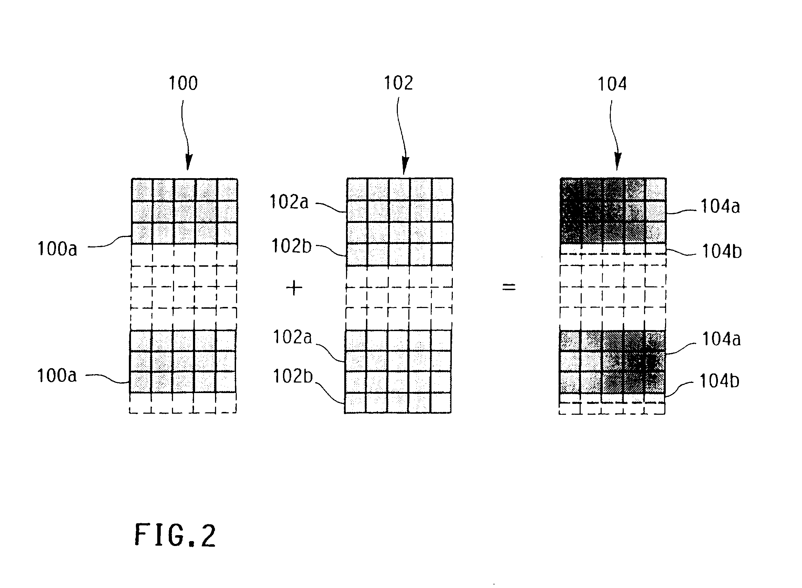

In Fig. 2 ist ein weiteres Beispiel dargestellt. In Fig. 2 sind dieselben Bezugszeichen wie in Fig. 1 verwendet.

Wie es in Fig. 2 zu sehen ist, besteht das erste Muster 100 dort aus zwei Teilmustern 100a und das zweite Muster 102 weist dementsprechend zwei Teilmuster auf. Der sich ergebende belichtete Bereich 104 weist ebenfalls zwei Teilbereiche auf. Durch das Plus-Zeichen ist die Überlagerung der beiden Muster 100, 102 angedeutet, aus denen sich der belichtete Bereich 104 ergibt, was durch das Istgleich-Zeichen dargestellt ist.

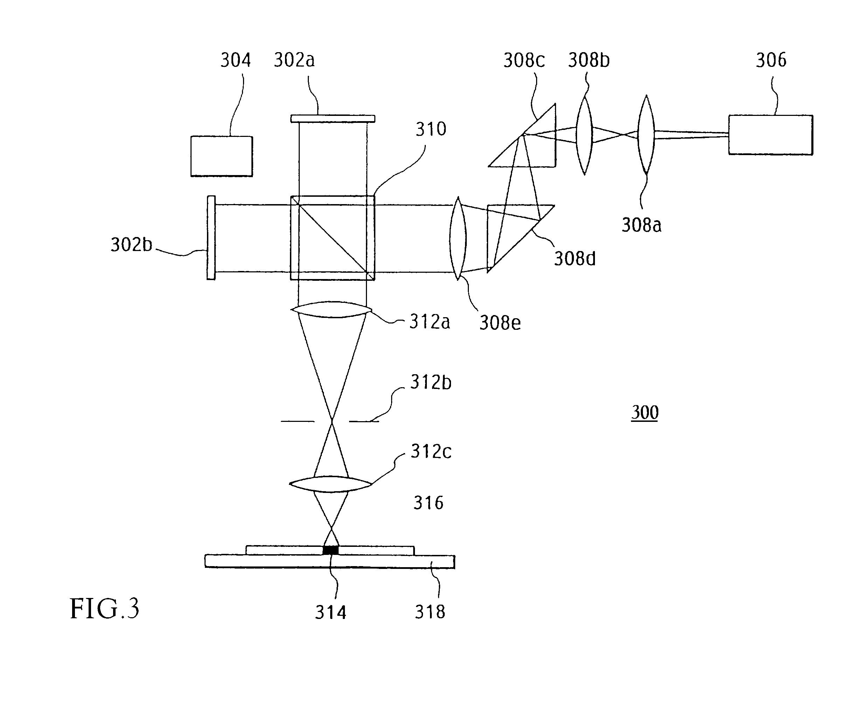

Anhand der Fig. 3 wird nachfolgend ein erstes bevorzugtes Ausführungsbeispiel der vorliegenden Erfindung näher erläutert.

Die erfindungsgemäße Vorrichtung ist in ihrer Gesamtheit mit dem Bezugszeichen 300 versehen. Die Vorrichtung 300 umfaßt zwei Flächenlichtmodulatoren 302a, 302b, die eine Mehrzahl von Bildelementen aufweist. Über eine Steuerung 304, die mit dem Flächenlichtmodulatoren verbunden ist, sind Muster auf diesem Flächenlichtmodulator 302 erzeugbar.

Von einer Lichtquelle 306, die bei diesem bevorzugten Ausführungsbeispiel eine gepulste Laserlichtquelle sein kann, wird das aus dieser austretende Licht über eine Strahlformungs- und -übertragungseinheit 308a - 308e und über einen Strahlteilerwürfel 310 auf die Flächenlichtmodulatoren 302a, 302b projiziert.

Das von den Flächenlichtmodulatoren reflektierte Licht tritt durch den Strahlteilerwürfel 310 hindurch und durchläuft eine sogenannte Projektions- oder Abbildungsoptik 312a, 312b, 312c und fällt abschließend auf einen zu belichtenden Bereich 314 einer zu strukturierenden Schicht 316.

Die zu strukturierende Schicht ist in diesem Ausführungsbeispiel auf einem verfahrbaren Positioniertisch 318 angeordnet.

Der Strahlteilerwürfel 310 ist dementsprechend ausgelegt, um den von der Lichtquelle 306 kommenden Strahl in zwei Teile aufzuspalten, um diese auf die jeweiligen Flächenlichtmodulatoren zu leiten.

Bei diesem Ausführungsbeispiel teilt der Strahlteilerwürfel 310 das von der Lichtquelle 306, die auch hier eine gepulste Laserlichtquelle sein kann, kommende Licht in zwei intensitätsgleiche Teilstrahlen.

Bei diesem Ausführungsbeispiel umfaßt das erfindungsgemäße Verfahren die folgenden Schritte:

In einem ersten Schritt wird ein erstes Muster auf dem ersten Flächenlichtmodulator 302a erzeugt, das durch eine vorbestimmte Anzahl von adressierten Bildelementen festgelegt ist. In einem zweiten Schritt wird gleichzeitig ein zweites Muster auf dem zweiten Flächenlichtmodulator 302b erzeugt, das einen ersten Bereich von adressierten Bildelementen aufweist, der mit dem ersten Musters übereinstimmt, und das unmittelbar benachbart zu dem ersten Bereich einen zweiten Bereich von adressierten Bildelementen aufweist. Anschließend wird das erste und das zweite Muster auf dem zu belichtenden Bereich 314 der zu strukturierenden Schicht 316 abgebildet.

Der zweite Bereich des zweiten Musters kann bei diesem Ausführungsbeispiel senkrecht zur Ausdehnungsrichtung des ersten Bereichs des zweiten Musters ein adressiertes Bildelement umfassen.

Um Strukturen in dem zu belichtenden Bereich zu erzeugen, deren Größe ungleich einem Vielfachen der Bildelementgröße auf den Flächenlichtmodulatoren 302a, 302b ist, wird auf dem Flächenlichtmodulator 302a ein erstes Muster mit einer Breite von i adressierten Bildelementen und auf dem zweiten Flächenlichtmodulator ein zweites Muster mit einer Breite von i+1 adressierten Bildelementen erzeugt. Als ein Ergebnis der Überlagerung der so erzeugten Teilbilder entsteht in dem zu belichtenden Bereich eine Struktur mit einer Größe von i+0,5 Bildelementen.

Das Zustandekommen dieser Struktur wurde bereits anhand der Fig. 1 und 2 beschrieben.

Werden bei dem Verfahren, das für die Vorrichtung aus Fig. 3 beschrieben wurde, die Interferenzbedingungen eingehalten, so ist die kohärente Überlagerung der einzelnen Teilbilder für die Erzeugung der Gesamtstruktur verantwortlich.

Um diese Interferenzbedingungen einzuhalten, müssen die auf den Flächenlichtmodulatoren erzeugten bzw. programmierten Muster gleichzeitig auf das zu belichtende Substrat abgebildet werden, die Differenz der Lichtwege von der Lichtquelle bzw. von unterschiedlichen, den einzelnen Flächenlichtmodulatoren zugeordneten Lichtquellen über die Flächenlichtmodulatoren zum Substrat muß kleiner sein als die Kohärenzlänge des verwendeten Lichtes und das Licht muß von einer Lichtquelle oder von unterschiedlichen Lichtquellen stammen, die miteinander interferieren können.

Das Abbildungsprinzip beruht dann darauf, daß durch die amplituden- und phasenrichtige Überlagerung der Lichterregungen der einzelnen Muster auf dem Flächenlichtmodulator ein virtuelles Muster erzeugt wird, das auf das Substrat abgebildet wird. Dieses Muster weist in den Randbereichen zusätzlich zur Phasenmodulation eine Intensitätsmodulation auf, die dazu führt, daß die Strukturkante verschoben wird (siehe Fig. 1). Dies ist durch die oben beschriebenen programmierten Flächenlichtmodulatoren mit unterschiedlichen programmierten Mustern erreichbar.

Werden die Interferenzbedingungen nicht eingehalten, so entsteht die Gesamtstruktur durch die inkohärente Überlagerung der einzelnen Teilbilder, wie es anhand von Fig. 1 beschrieben wurde.

Aufgrund der Struktur der einzelnen Flächenlichtmodulatoren ist es möglich, gleichzeitig Bereiche auf der zu strukturierenden Schicht unabhängig voneinander in x- und y-Richtung mit einem einzigen Teilbild zu belichten.

Es wird darauf hingewiesen, daß das in Fig. 3 beschriebene Ausführungsbeispiel nicht auf die Verwendung nur einer Lichtquelle 306 beschränkt ist, sondern daß anstelle der einen Lichtquelle 306 für die beiden Flächenlichtmodulatoren 302a, 302b auch zwei Lichtquellen benutzt werden könnten, die jeweils einem Flächenlichtmodulator 302a bzw. 302b zugeordnet sind.

In diesem Fall müßte eine geeignete Optik bereitgestellt werden, um die von den Flächenlichtmodulatoren reflektierten Strahlen gleichzeitig zu überlagern.

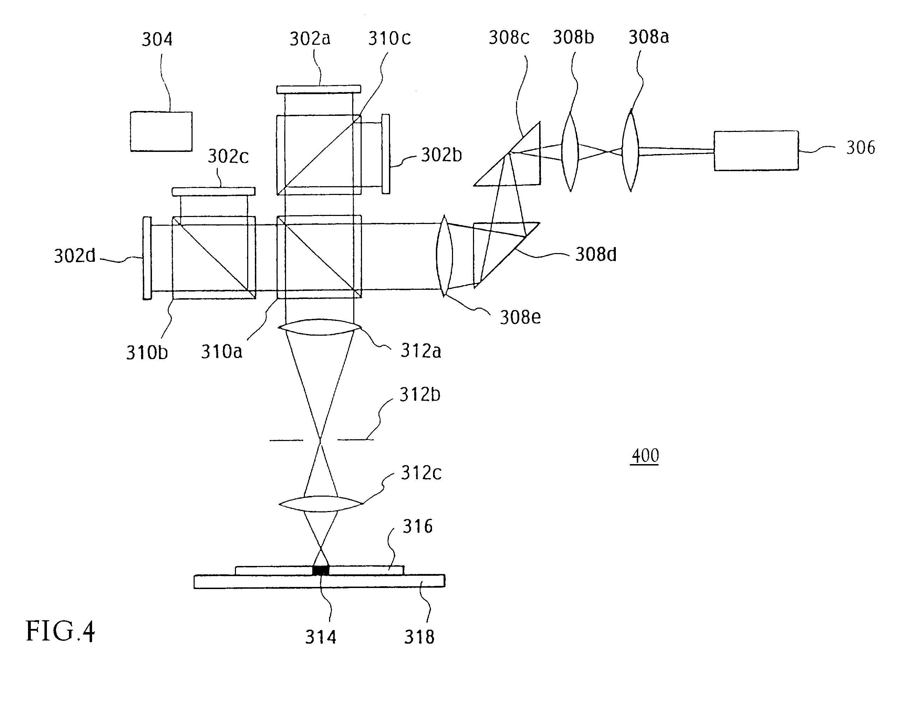

Anhand der Fig. 4 wird nachfolgend ein zweites Ausführungsbeispiel der erfindungsgemäßen Vorrichtung näher beschrieben. In Fig. 4 wurden dieselben Bezugszeichen für gleiche Elemente verwendet, die bereits anhand der Fig. 3 beschrieben wurden.

Die erfindungsgemäße Vorrichtung ist in ihrer Gesamtheit mit dem Bezugszeichen 400 bezeichnet.

Die Vorrichtung 400 unterscheidet sich von der in Fig. 3 dargestellten Vorrichtung dahingehend, daß anstelle der zwei Flächenlichtmodulatoren vier Flächenlichtmodulatoren 302a - 302d verwendet werden. Dementsprechend werden drei Strahlteilerwürfel 310a - 310c verwendet, um das Licht von der Lichtquelle 306 auf die einzelnen Flächenlichtmodulatoren 302a - 302d zu verteilen und zur Abbildung auf dem zu belichtenden Bereich 314 wieder zusammenzufassen.

Im Nachfolgenden wird anhand des Ausführungsbeispiels aus Fig. 4 die Erzeugung einer Adressierung einer 0,5 μm-Technologie mit einem benötigten Strukturelement von 0,05 μm näher erläutert.

Die Flächenlichtmodulatoren 302a - 302d weisen beispielsweise eine Breite der Bildelemente von 20 μm auf, und der Abbildungsmaßstab der Abbildungsoptik 312a - 312c beträgt 100:1. Die Breite eines Strukturinkrements beträgt somit 0,2 μm. Ausgehend von diesem Strukturinkrement wird mittels der vorliegenden Erfindung eine Verringerung um den Faktor 4 auf die benötigten 0,05 μm erreicht, wodurch Strukturbreiten von 0,50 μm, 0,55 μm, 0,60 μm, usw. belichtet werden können.

Eine 0,55 μm-Struktur entsteht auf die folgende Art: durch die N - 1 = 3 Strahlteiler (N = Anzahl der Flächenlichtmodulatoren) wird der Laserstrahl in N = 4 intensitätsgleiche Teilstrahlen aufgespalten, die jeweils auf einen zugeordneten Flächenlichtmodulator 302a - 302d treffen. Die zu erzeugende Struktur wird in die Summe aus einem ganzzahligen Vielfachen der Breite des Bildelements i x p und einen Rest Delta p zerlegt:

$$0,55 \ \mu m = i \ x \ p + Delta \ p = 2 \ x \ 0,20 \ \mu m + 0,15 \ \mu m.$$

Anschließend wird die Zahl j berechnet:

$$j = N \ x \ (Delta \ p/p) = 4 \ x \ (0,15 \ \mu m/0,20 \ \mu m) = 3$$

Bei allen N = 4 Flächenlichtmodulatoren werden dann i = 2 Bildelemente adressiert und das Bildelement i + 1 = 3 der Struktur wird für j = 3 Flächenlichtmodulatoren ebenfalls adressiert und für die übrigen N - j = 1 Flächenlichtmodulatoren nicht adressiert.

Durch diese Adressierung der N = 4 Flächenlichtmodulatoren wird auf der zu strukturierenden Schicht ein Bereich belichtet, der eine Breite von 0,55 μm hat.

Bei dem anhand der Fig. 4 beschriebenen Ausführungsbeispiel tritt bei Einhaltung der Interferenzbedingungen ebenfalls die bereits oben beschriebene kohärente Überlagerung auf.

Werden die Interferenzbedingungen nicht eingehalten, so werden die einzelnen Teilbilder inkohärent überlagert.

Es wird darauf hingewiesen, daß die anhand der Fig. 3 oder 4 beschriebenen Vorrichtungen, bei denen die verschiedenen Flächenlichtmodulatoren gleichzeitig auf das Substrat abgebildet werden, auf die nachfolgend beschriebenen Arten betrieben werden können.

In einer ersten Betriebsart sind alle Flächenlichtmodulatoren (zwei oder mehr) identisch, werden aber unterschiedlich programmiert bzw. weisen unterschiedliche Muster auf.

Diese Betriebsart wird eingesetzt, um das Strukturinkrement der Abbildung unter die durch die Pixelabmessungen auf dem Flächenlichtmodulator multipliziert mit dem Abbildungsmaßstab der Abbildungsoptik vorgegebene Größe zu verringern, wie dies bereits oben beschrieben wurde.

In einer zweiten Betriebsart sind alle Flächenlichtmodulatoren identisch und gleich programmiert bzw. weisen gleiche Muster auf.

Diese Betriebsart wird verwendet, um die Energie der Lichtquelle vollständig zur Beleuchtung von Flächenlichtmodulatoren zu nutzen, so daß die Belichtung des Substrats mit einer um den Faktor Zwei geringeren Lichtenergie ermöglicht wird - verglichen mit herkömmlichen Geräten.

In einer dritten Betriebsart sind die Flächenlichtmodulatoren nicht identisch.

Diese Betriebsart kommt dann zum Einsatz, wenn für bestimmte Anwendungen der Einsatz von Flächenlichtmodulatoren mit einem fest eingeprägten Muster (passive Elemente) sinnvoll ist, z.B. zur Erzeugung von Mustern mit einem hohen Grad an Strukturwiederholungen. Wahlweise können hierbei dann einzelne Flächenlichtmodulatoren (entweder aktive Matrix-adressierbare oder die passiven Elemente) durch Shutter nicht beleuchtet werden und tragen somit nicht zur Abbildung bei.

**Patentansprüche**

1. Verfahren zum Strukturieren einer photolithographischen Schicht, mit folgenden Schritten:

a) Erzeugen eines ersten Musters (100) auf einem ersten Flächenlichtmodulator (302a), wobei der erste Flächenlichtmodulator (302a) eine Mehrzahl von Bildelementen aufweist, wobei das erste Muster (100) durch eine vorbestimmte Anzahl von adressierten Bildelementen festgelegt ist; und

b) Abbilden des ersten Musters (100) auf einem zu belichtenden Bereich (314) der zu strukturierenden Schicht (316) ;

gekennzeichnet durch

c) Erzeugen eines zweiten Musters (102) auf einem zweiten Flächenlichtmodulator (302b), wobei der zweite Flächenlichtmodulator (302b) eine Mehrzahl von Bildelementen aufweist, wobei das zweite Muster (102) einen ersten Bereich (102a) von adressierten Bildelementen, der mit dem ersten Muster oder einem Teil daraus (100) übereinstimmt, und unmittelbar benachbart zu diesem einen zweiten Bereich (102b) von adressierten Bildelementen aufweist; und

d) Abbilden des zweiten Musters (102) auf dem zu belichtenden Bereich (314) der zu strukturierenden Schicht (316);

wobei das erste und das zweite Muster (100, 102) gleichzeitig auf den zu belichtenden Bereich (314) der zu strukturierenden Schicht (316) abgebildet werden.

2. Verfahren nach Anspruch 1, dadurch gekennzeichnet,

daß der zweite Bereich (102b) des zweiten Musters senkrecht zur Ausdehnungsrichtung des ersten Bereichs (102a) des zweiten Musters ein adressiertes Bildelement umfaßt.

3. Verfahren nach Anspruch 1 oder 2, dadurch gekennzeichnet,

daß der erste und der zweite Flächenlichtmodulator (302a, 302b) von einer Lichtquelle (306) beleuchtet werden.

4. Verfahren nach Anspruch 3, dadurch gekennzeichnet,

daß die Differenz der Lichtwege von der Lichtquelle (306) über den ersten und den zweiten Flächenlichtmodulator (302a, 302b) zu der zu strukturierenden Schicht (316) kleiner ist als die Kohärenzlänge des Lichtes der Lichtquelle (306).

5. Verfahren nach Anspruch 1 oder 2, dadurch gekennzeichnet,

daß der erste und der zweite Flächenlichtmodulator (302a, 302b) von einer ersten und einer zweiten Lichtquelle belichtet werden, wobei die erste und die zweite Lichtquelle miteinander interferieren.

6. Verfahren nach Anspruch 5, dadurch gekennzeichnet,

daß die Differenz der Lichtwege von der ersten Lichtquelle über den ersten Flächenlichtmodulator (302a) und von der zweiten Lichtquelle über den zweiten Flächenlichtmodulator (302b) zu der zu strukturierenden Schicht (316) kleiner ist als die Kohärenzlänge des Lichtes der Lichtquelle (306).

7. Vorrichtung zum Strukturieren einer photolithographischen Schicht, mit

- einem ersten Flächenlichtmodulator (302a) mit einer Mehrzahl von Bildelementen zum Erzeugen eines ersten Musters (100), das durch eine vorbestimmte Anzahl von adressierten Bildelementen festgelegt ist; und

- einer Abbildungseinrichtung (312a - 312c), die das erste Muster auf einen zu belichtenden Bereich (314) der zu strukturierenden Schicht (316) abbildet;

gekennzeichnet durch

- einen zweiten Flächenlichtmodulator (302b) mit einer Mehrzahl von Bildelementen zum Erzeugen eines zweiten Musters (102), das einen ersten Bereich von adressierten Bildelementen, der mit dem ersten Muster oder einem Teil daraus übereinstimmt, und unmittelbar benachbart zu diesem einen zweiten Bereich von adressierten Bildelementen aufweist; und

wobei die Abbildungseinrichtung (312a - 312c) das zweite Muster auf den zu belichtenden Bereich (314) der zu strukturierenden Schicht (316) abbildet;

wobei die Abbildungseinrichtung (312a - 312c) das erste und das zweite Muster (100, 102) gleichzeitig auf den zu belichtenden Bereich (314) der zu strukturierenden Schicht (316) abbildet.

8. Vorrichtung nach Anspruch 7, dadurch gekennzeichnet,

daß der zweite Bereich (102b) des zweiten Musters senkrecht zur Ausdehnungsrichtung des ersten Bereichs (102a) des zweiten Musters ein adressiertes Bildelement aufweist.

9. Vorrichtung nach Anspruch 7 oder 8, gekennzeichnet durch

eine erste Lichtquelle, die dem ersten Flächenlichtmodulator zugeordnet ist; und

eine zweite Lichtquelle, die dem zweiten Flächenlichtmodulator zugeordnet ist, deren Licht mit dem Licht der ersten Lichtquelle interferieren kann.

10. Vorrichtung nach Anspruch 9, dadurch gekennzeichnet,

daß die Differenz der Lichtwege von der ersten Lichtquelle über den ersten Flächenlichtmodulator (302a) und von der zweiten Lichtquelle über den zweiten Flächenlichtmodulator (302b) zu der zu strukturierenden Schicht (316) kleiner ist als die Kohärenzlänge des Lichtes der Lichtquelle (306).

11. Vorrichtung nach Anspruch 7 oder 8, gekennzeichnet durch

eine Lichtquelle (306); und

eine Strahlteilereinrichtung (310), die den Lichtstrahl von der Lichtquelle (306) auf den ersten und auf den zweiten Flächenlichtmodulator (302a, 302b) richtet.

12. Vorrichtung nach Anspruch 11, dadurch gekennzeichnet,

daß die Differenz der Lichtwege von der Lichtquelle (306) über den ersten und den zweiten Flächenlichtmodulator (302a, 302b) zu der zu strukturierenden Schicht (316) kleiner ist als die Kohärenzlänge des Lichtes der Lichtquelle (306).

13. Vorrichtung nach Anspruch 11 oder 12, dadurch gekennzeichnet,

daß die Strahlteilereinrichtung (310) den Lichtstrahl von der Lichtquelle (306) in zwei intensitätsgleiche Strahlen aufteilt.

14. Vorrichtung nach einem der Ansprüche 9 bis 13, dadurch gekennzeichnet,

daß die Lichtquelle (306) eine gepulste Laserlichtquelle ist.

15. Vorrichtung nach einem der Ansprüche 7 bis 14, gekennzeichnet durch

einen beweglichen Positioniertisch (318), auf dem die zu strukturierende Schicht (316) festlegbar ist.

## Claims

1. A method for structuring a photolithographic layer, comprising the following steps:

a) creating a first pattern (100) on a first plane light modulator (302a), where the first plane light modulator (302a) comprises a plurality of picture elements, where the first pattern (100) is defined by a prescribed number of addressed picture elements;

b) imaging the first pattern (100) onto a region (314) to be exposed of the layer (316) to be structured;

characterized by

c) creating a second pattern (102) on a second plane light modulator (302b), where the second plane light modulator (302b) comprises a plurality of picture elements, where the second pattern (102) comprises a first region (102a) of addressed picture elements, which matches the first pattern or part thereof (100), and immediately adjacent to this a second region (102b) of addressed picture elements; and

d) imaging the second pattern (102) onto the region (314) to be exposed of the layer (316) to be structured;

wherein the first and the second pattern (100, 102) are imaged simultaneously onto the region (314) to be exposed of the layer (316) to be structured.

2. A method according to claim 1, characterized in that the second region (102b) of the second pattern comprises an addressed picture element at right angles to the extension direction of the first region (102a) of the second pattern.

3. A method according to claim 1 or 2, characterized in that

the first and the second plane light modulator (302a, 302b) are illuminated by a light source (306).

4. A method according to claim 3, characterized in that

the difference in the light paths from the light source (306) via the first and the second plane light modulator (302a, 302b) to the layer (316) to be structured is less than the coherence length of the light of the light source (306).

5. A method according to claim 1 or 2, characterized in that

the first and the second plane light modulator are illuminated by a first and a second light source, where the first and the second light source interfere with each other.

6. A method according to claim 5, characterized in that

the difference in the light paths from the first light source via the first plane light modulator (302a) and from the second light source via the second plane light modulator (302b) to the layer (316) to be structured is less than the coherence length of the light of the light source (306).

7. A device for structuring a photolithographic layer, comprising:

- a first plane light modulator (302a) with a plurality of picture elements for creating a first pattern (100), which is defined by a prescribed number of addressed picture elements;

- an imaging device (312a - 312c), which images the first pattern onto a region (314) to be exposed of the layer (316) to be structured;

charcterized by

- a second plane light modulator (302b) with a plurality of picture elements for creating a second pattern (102), which comprises a first region (102a) of addressed picture elements, which matches the first pattern or part thereof, and immediately adjacent to this a second region (102b) of addressed picture elements;

wherein the imaging device (312a - 312c) images the second pattern onto the region (314) to be exposed of the layer (316) to be structured;

wherein the imaging device (312a - 312c) images the first and the second pattern (100, 102) simultaneously onto the region (314) to be exposed of the layer (316) to be structured.

8. A device according to claim 7, characterized in that

the second region (102b) of the second pattern has an addressed picture element at right angles to the extension direction of the first region (102a) of the second pattern.

9. A device according to claim 7 or 8, characterized by

a first light source, which is assigned to the first plane light modulator; and

a second light source, which is assigned to the second plane light modulator, whose light can interfere with the light of the first light source.

10. A device according to claim 9, characterized in that

the difference in the light paths from the first light source via the first plane light modulator (302a) and from the second light source via the second plane light modulator (302b) to the layer (316) to be structured is less than the coherence length of the light of the light source (306).

11. A device according to claim 7 or 8, characterized by

a light source (306); and

a beam splitting device (310) which directs the light beam from the light source (306) onto the first and onto the second plane light modulator (302a, 302b).

12. A device according to claim 11, characterized in that

the difference in the light paths from the light source (306) via the first and the second plane light modulator (302a. 302b) to the layer (316) to be structured is less than the coherence length of the light of the light source (306).

13. A device according to claim 11 or 12, characterized in that

the beam splitting device (310) splits the light beam from the light source (306) into two beams of equal light intensity.

14. A device according to any one of the claims 9 to 13, characterized in that

the light source (306) is a pulsed laser light source.

15. A device according to any one of the claims 7 to 14, charcterized by

a movable positioning table (318), on which the layer (316) to be structured can be mounted.

**Revendications**

1. Procédé de structuration d'une couche photolithographique, aux étapes suivantes consistant à :

a) générer un premier motif (100) sur un premier modulateur de faisceau lumineux plan horizontal (302a), le premier modulateur de faisceau lumineux plan horizontal (302a) présentant une pluralité d'éléments d'image, le premier motif (100) étant fixé par un nombre prédéterminé d'éléments d'image adressés; et

b) reproduire le premier motif (100) sur une zone à exposer (314) de la couche à structurer (316);

caractérisé par

c) la génération d'un second motif (102) sur un second modulateur de faisceau lumineux plan horizontal (302b), le second modulateur de faisceau lumineux plan horizontal (302b) présentant une pluralité d'éléments d'image, le second motif (102) présentant une première zone (102a) d'éléments d'image adressés correspondant au premier motif ou à une partie de celui-ci (100) et, immédiatement adjacente à cette dernière, une seconde zone (102b) d'éléments d'image adressés; et

d) la reproduction du second motif (102) sur la zone à exposer (314) de la couche à structurer (316);

les premier et second motifs (100, 102) étant reproduits simultanément sur la zone à exposer (314) de la couche à structurer (316).

2. Procédé suivant la revendication 1, caractérisé par le fait que la seconde zone (102b) du second motif comprend, perpendiculairement à la direction d'extension de la première zone (102a) du second motif, un élément d'image adressé.

3. Procédé suivant la revendication 1 ou 2, caractérisé par le fait que les premier et second modulateurs de faisceau lumineux plan horizontal (302a, 302b) sont éclairés par une source de lumière (306).

4. Procédé suivant la revendication 3, caractérisé par le fait que la différence entre les trajectoires de lumière de la source de lumière (306), via les premier et second modulateurs de faisceau lumineux plan horizontal (302a, 302b), à la couche à structurer (316), est inférieure à la longueur de cohérence de la lumière de la source de lumière (306).

5. Procédé suivant la revendication 1 ou 2, caractérisé par le fait que les premier et second modulateurs de faisceau lumineux plan horizontal (302a, 302b) sont éclairés par une première et une seconde source de lumière, les première et seconde sources de lumière interférant l'une avec l'autre.

6. Procédé suivant la revendication 5, caractérisé par le fait que la différence entre les trajectoires de lumière de la première source de lumière, via le premier modulateur de faisceau lumineux plan horizontal (302a), et de la seconde source de lumière, via le second modulateur de faisceau lumineux plan horizontal (302b), à la couche à structurer (316), est inférieure à la longueur de cohérence de la lumière de la source de lumière (306).

7. Dispositif de structuration d'une couche photolithographique, avec :

- un premier modulateur de faisceau lumineux plan horizontal (302a) avec une pluralité d'éléments d'image, destiné à générer un premier motif (100) qui est fixé par un nombre prédéterminé d'éléments d'image adressés ; et
- un dispositif de reproduction (312a - 312c) qui reproduit le premier motif sur une zone à exposer (314) de la couche à structurer (316) ;

caractérisé par

- un second modulateur de faisceau lumineux plan horizontal (302b) avec une pluralité d'éléments d'image, destiné à générer un second motif (102) présentant une première zone d'éléments d'image adressés correspondant au premier motif ou à une partie de celui-ci et, immédiatement adjacente à cette dernière, une seconde zone d'éléments d'image adressés; et

le dispositif de reproduction (312a - 312c) reproduisant le second motif sur la zone à exposer (314) de la couche à structurer (316); le dispositif de reproduction (312a - 312c) reproduisant simultanément les premier et second motifs (100, 102) sur la zone à exposer (314) de la couche à structurer (316).

8. Dispositif suivant la revendication 7, caractérisé par le fait que la seconde zone (102b) du second motif présente, perpendiculairement à la direction d'extension de la première zone (102a) du second motif, un élément d'image adressé.

9. Dispositif suivant la revendication 7 ou 8, caractérisé par

une première source de lumière qui est associée au premier modulateur de faisceau lumineux plan horizontal ; et
une seconde source de lumière qui est associée au second modulateur de faisceau lumineux plan horizontal dont la lumière peut interférer avec la lumière de la première source de lumière.

**10.** Dispositif suivant la revendication 9, caractérisé par le fait que la différence entre les trajectoires de lumière de la première source de lumière, via le premier modulateur de faisceau lumineux plan horizontal (302a), et de la seconde source de lumière, via le second modulateur de faisceau lumineux plan horizontal (302b), à la couche à structurer (316), est inférieure à la longueur de cohérence de la lumière de la source de lumière (306).

**11.** Dispositif suivant la revendication 7 ou 8, caractérisé par

une source de lumière (306); et
un dispositif de guidage de faisceau (310) qui oriente le faisceau lumineux de la source de lumière (306) sur le premier et sur le second modulateur de faisceau lumineux plan horizontal (302a, 302b).

**12.** Dispositif suivant la revendication 11, caractérisé par le fait que la différence entre les trajectoires de lumière de la source de lumière (306), via les premier et second modulateurs de faisceau lumineux plan horizontal (302a, 302b), à la couche à structurer (316), est inférieure à la longueur de cohérence de la lumière de la source de lumière (306).

**13.** Dispositif suivant la revendication 11 ou 12, caractérisé par le fait que le dispositif de guidage de faisceau (310) divise le faisceau lumineux provenant de la source de lumière (306) en deux faisceaux de même intensité.

**14.** Dispositif suivant l'une des revendications 9 à 13, caractérisé par le fait que la source de lumière (306) est une source de lumière à laser pulsée.

**15.** Dispositif suivant l'une des revendications 7 à 14, caractérisé par un plateau de positionnement mobile (318) sur lequel peut être fixée la couche à structurer (316).

FLÄCHENLICHTMODULATOR

BELICHTETER BEREICH

FIG.1

EP 0 811 181 B1

FIG.2

FIG.3

FIG.4

EP 0 811 181 B1